# EUROPÄISCHE PATENTSCHRIFT

(11) **EP 3 047 207 B1**
(45) Veröffentlichungstag und Bekanntmachung des Hinweises auf die Patenterteilung: **30.06.2021**
(21) Anmeldenummer: 14781441.2
(22) Anmeldetag: 19.09.2014
(51) Int. Cl.: H03K 17/94, H05B 33/08, H05B 45/00, H05K 1/03, H05K 1/18, F21V 23/04, F21V 23/00, F21Y 101/00, F21Y 115/10, F21Y 107/10

(54) **SENSOREINHEIT ZUR LICHTSTEUERUNG**
SENSOR UNIT FOR LIGHT CONTROL
UNITÉ DE CAPTEUR POUR COMMANDER LA LUMIÈRE

(30) Priorität: 20.09.2013 DE 102013219011
(43) Veröffentlichungstag der Anmeldung: 27.07.2016
(73) Patentinhaber: SITECO GmbH, 83301 Traunreut (DE)
(72) Erfinder: LOSTER, Matthias, 93047 Regensburg (DE); KRÄUTER, Gertrud, 93051 Regensburg (DE); MEYER, Clemens, 83278 Traunstein (DE)
(74) Vertreter: Schohe, Stefan
(86) Internationale Anmeldenummer: PCT/EP2014/002647
(87) Internationale Veröffentlichungsnummer: WO 2015/039764

(56) Entgegenhaltungen:
- WO-A1-2008/135898
- WO-A1-2009/059453
- WO-A1-2010/115801
- DE-A1- 10 106 183
- US-A1- 2003 117 803
- US-A1- 2004 232 812
- US-A1- 2010 255 742

## Beschreibung

### Technisches Gebiet

Die vorliegende Erfindung betrifft eine Sensoreinheit zur Lichtsteuerung mit einem Substratkörper und einem Sensorelement.

### Stand der Technik

Aus dem Stand der Technik ist es bekannt, zur Erfassung von Daten für die Ansteuerung einer Lichtquelle einen Bewegungsmelder vorzusehen, der in seinem Erfassungsbereich die Bewegung eines Objekts detektieren kann. Auf eine entsprechende Erfassung hin wird dann beispielsweise die Lichtquelle über eine Steuereinheit eingeschaltet und etwa nach Ablauf einer vordefinierten Zeitdauer wieder ausgeschaltet.

WO 2010/115801 A1 offenbart ein Retrofit-LED-Modul, das einen Träger aufweist, auf dem ein Sensor angebracht ist, der die integrierte Amplitude des ausgestrahlten Lichts des Retrofit-LED-Moduls misst. Ein weiterer Sensor, der die Umgebungshelligkeit umfasst, ist nicht auf dem Träger, sondern davon separat am Rand der Oberseite des Retrofit-LED-Moduls angebracht. Das Retrofit-LED-Modul weist eine Elektronik zur Ansteuerung der LED auf, welche die Sensoren umfasst und eine Steuerschaltung aufweist, welche die Signale der Sensoren verarbeitet.

US 2003/0117803 A1 offenbart eine LED - Lampe, bei der auf einer konvex gebogenen Platte eine Vielzahl von LED sowie ein Anwesenheitssensor angeordnet sind und ein Lichtsensor seitlich an dem Basisteil der Lampe angeordnet ist.

Der vorliegenden Erfindung liegt das technische Problem zugrunde, eine besonders vorteilhafte Sensoreinheit zur Lichtsteuerung anzugeben.

### Darstellung der Erfindung

Erfindungsgemäß löst diese Aufgabe eine Sensoreinheit nach Anspruch 1.

Bevorzugte Ausführungsformen finden sich in den abhängigen Ansprüchen und der nachstehenden Beschreibung, wobei nicht immer im Einzelnen zwischen der Darstellung von Vorrichtungs-, Verfahrens- und Verwendungsaspekten unterschieden wird. Jedenfalls implizit ist die Offenbarung hinsichtlich sämtlicher Anspruchskategorien zu lesen.

Erfindungsgemäß sind auf dem Substratkörper also mindestens zwei Sensorelemente angeordnet und gemäß Variante 1 derart ausgerichtet, dass die jeweiligen Erfassungsbereiche allenfalls teilweise überlappen. In anderen Worten soll dann ein Gesamterfassungsbereich, der sich gewissermaßen als Vereinigungsmenge der einzelnen Erfassungsbereiche ergibt, größer als die einzelnen Erfassungsbereiche sein. Mit der erfindungsgemäßen Einheit wird ein räumlich vergrößerter, je nach Anwendungsgebiet anpassbarer Gesamterfassungsbereich möglich. Dabei ist keine Anpassung auf

Sensorelement-Ebene (des Sensorelement-Typs) notwendig, was zum Beispiel den logistischen Aufwand in der Fertigung reduzieren helfen kann.

Der dabei als Substratkörper vorgesehene "urgeformte" Schaltungsträger ist ein fester Körper, der aus einem zuvor in der Regel zumindest zeitweise formlosen Stoff hergestellt wurde, beispielsweise als Extrusionsteil (extrudierter Schaltungsträger) oder vorzugsweise als Spritzgussteil (spritzgegossener Schaltungsträger). Entsprechend lassen sich die Anordnungsmöglichkeiten der Sensorelemente erweitern und können die Erfassungsbereiche insbesondere auch mit zueinander verkippten jeweiligen Haupterfassungsrichtungen angeordnet werden.

Zum Vergleich könnten beispielsweise auf einer ebenen FR4-Leiterplatte die Sensorelemente lediglich seitlich zueinander versetzt in derselben Ebene, also mit parallelen Haupterfassungsrichtungen, angeordnet werden bzw. müssten für eine Verkippung zusätzlich gewinkelte Haltevorrichtungen montiert werden, was einen Mehraufwand bedeutet und auch die Wahrscheinlichkeit von Montagefehlern erhöht.

Indem der Substratkörper zugleich Schaltungsträger ist, ist die Integrationstiefe ferner noch weiter erhöht, weil auch eine Leiterbahnfunktion übernommen wird. Die Sensorelemente können beispielsweise über eine integrierte Leiterbahnstruktur miteinander und/oder mit einer in bevorzugter Ausgestaltung auch auf dem Substratkörper angeordneten Steuereinheit elektrisch leitend verbunden sein. Die auf dem Substratkörper "angeordneten" Sensorelemente bzw. weiteren Bauelemente sind gegenüber dem Substratkörper lagefixiert, und zwar vorzugsweise über eine flächige Verbindung, etwa über eine Fügeverbindung; besonders bevorzugt sind sie aufgeklebt oder aufgelötet.

Ein "Erfassungsbereich" kann zum Beispiel das Volumen sein, innerhalb welchem das jeweilige Sensorelement mit einer Wahrscheinlichkeit von mindestens 70 %, 80 %, 90 %, 95 %, 97 %, 98 % bzw. 99 % detektiert, etwa im Falle eines zur Erfassung einer Bewegung vorgesehenen Sensorelements. Im Falle eines zur Erfassung einer Helligkeit/Helligkeitsänderung vorgesehenen Sensorelements kann der "Erfassungsbereich" bspw. der Raumwinkelbereich sein, aus dem Licht auf den aktiven (der Erfassung dienenden) Bereich des Sensorelements fällt, wobei sich der Erfassungsbereich dann bis zu einem Abstand von nicht mehr als 10 m, in dieser Reihenfolge zunehmend bevorzugt nicht mehr als 8 m, 6 m, 5 m, 4 m, 3 m, 2 m bzw. 1 m, zum Sensorelement erstreckt (es ist also wiederum ein Volumen definiert).

Hinsichtlich einer Erweiterung des Gesamterfassungsbereichs kann bevorzugt sein, dass nicht mehr als 50 %, in dieser Reihenfolge zunehmend bevorzugt nicht mehr als 40 %, 30 % bzw. 20 %, des ersten Erfassungsbereichs mit dem zweiten überlappen. Die Erfassungsbereiche können insoweit als dreidimensionale Volumina betrachtet werden, deren Schnittmenge (also deren "Dbertapp") betrachtet und hinsichtlich ihres Volumens mit jenem des ersten Erfassungsbereichs verglichen wird.

Gemäß der Erfindung ist zumindest ein Bereich der Oberfläche des Substratkörpers zumindest teilweise konvex ausgebildet und sind das erste und/oder das zweite Sensorelement in diesem Oberflächenbereich angeordnet. Dabei meint "zumindest teilweise konvex", dass in einer Schnittebene betrachtet, welche eine Normale auf die Oberfläche beinhaltet, zumindest eine an die Oberfläche gelegte Ausgleichskurve, etwa ein Polynom zweiten Grades, konvex ist. Hinsichtlich einer Umlaufrichtung um die entsprechende Normale gilt dies vorzugsweise für sämtliche (die Normale beinhaltende) Schnittebenen in einem Winkelbereich von mindestens 180°, 270° bzw. 315°. Im Allgemeinen soll die "teilweise konvexe" Ausgestaltung also beispielsweise keine geringfügige lokale Vertiefung ausschließen.

Vorzugsweise ist der zumindest teilweise konvexe Oberflächenbereich jedoch frei von konkaven Abschnitten, ist die Oberfläche in dem Bereich also konvex bzw. allenfalls bereichsweise planar. Generell lässt sich durch die Anordnung eines Sensorelements in einem (teilweise) konvexen Oberflächenbereich die Gefahr einer "Abschattung" des Erfassungsbereichs durch den Substratkörper verringern und können die Erfassungsbereiche zudem winkelverkippt zueinander vorgesehen werden.

Im Allgemeinen soll eine teilweise Abschattung eines Erfassungsbereichs durch den Substratkörper indes selbstverständlich nicht ausgeschlossen sein. Sie kann sogar von Interesse sein, um beispielsweise bestimmte Raumwinkel/Volumina von der Erfassung auszunehmen; im Falle einer auf dem Substratkörper vorgesehenen Lichtquelle kann der Substratkörper das Sensorelement bspw. (auch) gegenüber dieser abschatten.

Bei einer bevorzugten Ausführungsform sind das erste und/oder das zweite Sensorelement dazu ausgelegt, eine Bewegung eines sich im jeweiligen Erfassungsbereich bewegenden Objekts zu detektieren. Das Sensorelement dient also einer Bewegungserfassung und kann eine solche etwa über elektromagnetische Wellen (zum Beispiel Radar), über Ultraschall und/oder vorzugsweise über die Infrarotstrahlung, also etwa als PIR-Sensorelement (*passive infrared*), erfassen. Neben einer Vergrößerung des Gesamterfassungsbereichs kann bei einer erfindungsmäßigen Sensoreinheit indes auch der Überlapp an sich vorteilhaft sein, weil so die Auflösung verbessert werden kann, etwa im Falle von PIR-Sensorelementen.

In bevorzugter Ausgestaltung sind das erste und/oder das zweite Sensorelement zur Erfassung einer Helligkeit und/oder einer Helligkeitsänderung vorgesehen. Auf das entsprechende Sensorelement fallendes Licht kann also beispielsweise über einen sich ändernden Widerstand (Fotowiderstand), eine Fotodiode oder ein CCD-Sensorelement (*charge-coupled device*) erfasst werden.

Die optoelektronische Lichtquelle kann dann beispielsweise derart angesteuert werden, dass eine sich ändernde Umgebungshelligkeit zumindest teilweise ausgeglichen wird, also die Lichtquelle beispielsweise bei abnehmendem Tageslicht eingeschaltet bzw. mit erhöhter Leistung betrieben wird. Ein zur Erfassung der Helligkeit vorgesehenes Sensorelement kann, soweit in bevorzugter Ausgestaltung auch die optoelektronische Lichtquelle auf dem Substratkörper angeordnet ist, dann beispielsweise in einem der Lichtquelle entgegengesetzten Oberflächenbereich angeordnet werden. So lässt sich beispielsweise die Gefahr verringern, dass originär von der Lichtquelle emittiertes und rückreflektiertes Licht auf das Sensorelement fällt und die Erfassung verfälscht.

Gemäß der Erfindung ist zusätzlich zu den Sensorelementen auch die optoelektronische Lichtquelle auf dem Substratkörper angeordnet, besonders bevorzugt ist eine Mehrzahl optoelektronischer Lichtquellen darauf angeordnet, was die Integrationstiefe weiter erhöht. Es dient nämlich dann derselbe Substratkörper der räumlichen Ausrichtung der Erfassungsbereiche und zugleich der Ausrichtung des/der von der optoelektronischen Lichtquelle emittierten Strahlenbündel(s).

Der Begriff "optoelektronische Lichtquelle" (im Folgenden auch nur "Lichtquelle") kann sowohl eine für sich gehäuste LED als im Allgemeinen auch einen für sich ungehäusten LED-Chip meinen; ein LED-Chip kann etwa auch als *Flip-Chip* auf den Substratkörper gesetzt werden. Vorzugsweise wird auf dem Substratkörper jedoch eine bereits zuvor für sich gehäuste LED angeordnet, die also ein eigenes Gehäuse hat (in einem Gehäuse können dabei auch mehrere LED-Chips vorgesehen sein), und bezieht sich "Lichtquelle" darauf; "Gehäuse" meint insoweit eine gewisse, nicht notwendigerweise vollständige Ummantelung mit beispielsweise einem Vergussmaterial, üblicherweise zusammen mit einem der elektrischen und/oder thermischen Kontaktierung dienenden Trägerelement.

Gemäß der Erfindung ist die Lichtquelle derart auf der Oberfläche des Substratkörpers angeordnet, dass ein Teil des von ihr emittierten Lichts auf die Substratkörperoberfläche fällt. Durch diese teilweise Abschattung übernimmt der Schaltungsträger zusätzlich eine lichtformende Funktion, bestimmt also die räumliche Abstrahlcharakteristik nicht nur hinsichtlich der Ausrichtung mit. Der Substratkörper selbst ist dabei vorzugsweise nicht transmissiv, es erfolgt insbesondere keine diffuse Transmission, wenngleich selbstverständlich transmissive Bereiche in den Substratkörper eingearbeitet sein können, etwa ein Loch darin vorgesehen sein kann. Jedenfalls "schneidet" der Substratkörper durch die Abschattung gewisse Winkel aus dem von der Lichtquelle emittierten Strahlenbündel aus, wobei das abgeschattete (ausgeschnittene) Licht vom Substratkörper absorbiert und/oder reflektiert werden kann.

In bevorzugter Ausgestaltung sind die Lichtquelle und der Substratkörper solchermaßen vorgesehen, dass in einer den Schwerpunktstrahl der Lichtquelle beinhaltenden Schnittebene betrachtet mindestens das sich innerhalb eines zusammenhängenden ersten Abschattungswinkelbereichs von 20° ausbreitende Licht auf den Substratkörper fällt. Der Scheitel des Abschattungswinkels liegt dabei im Schnittpunkt zwischen Schwerpunktstrahl und Abstrahlfläche.

Der Abschattungswinkelbereich kann in dieser Reihenfolge zunehmend bevorzugt mindestens 30°, 40°, 50°, 60°, 70°, 80° bzw. 85° betragen. Der "Schwerpunktstrahl" ergibt sich als Schwerpunktstrahl der nach der Leistung gewichteten Strahlen des von der LED emittierten Strahlenbündels; etwa im Falle einer rechteckigen, Lambertsch emittierenden Abstrahlfläche liegt er im Flächenmittelpunkt senkrecht auf die Abstrahlfläche.

In bevorzugter Ausgestaltung ist der Abschattungswinkelbereich gegenüber dem Schwerpunktstrahl maximal verkippt - der Abschattungswinkelbereich ist ein mit Licht "gefüllter" Bereich, es soll also das von der LED emittierte Strahlenbündel vom Rand (maximale Verkippungswinkel) beginnend abgeschattet werden. In anderen Worten wird also mit gegenüber dem Schwerpunktstrahl maximal verkippten Strahlen beginnend abgeschattet. Je nach Ausdehnung des Abschattungswinkelbereichs kann dieser dann bis zum Schwerpunktstrahl oder auch darüber hinaus reichen.

Dies alles gilt vorzugsweise nicht nur für eine erste Lichtquelle, sondern auch für ein zweite Lichtquelle und besonders bevorzugt weitere Lichtquellen, etwa mindestens 2, 5, 8 bzw. 10 Lichtquellen. Eine entsprechende Mehrzahl Lichtquellen kann generell bevorzugt sein. Unabhängig davon kann auch eine Vielzahl auf dem Substratkörper angeordnete Sensorelemente bevorzugt sein, also etwa mindestens 3, 4, 5, 6, 7, 8, 9 bzw. 10 Sensorelemente.

Bei einer bevorzugten Ausführungsform ist eine zweite Lichtquelle in dem Bereich der Oberfläche angeordnet ist, auf welchen ein Teil des von der ersten Lichtquelle emittierten Lichts direkt (ohne vorheriger Reflexion) fällt. Dies gilt besonders bevorzugt jeweils paarweise für mindestens 25 %, 50 %, 75 % der Lichtquellen bzw. sämtliche Lichtquellen.

Bei einer bevorzugten Ausführungsform hat ein Bereich der Oberfläche, in welchem Lichtquellen angeordnet sind, in einer den Gesamtschwerpunktstrahl der Sensoreinheit beinhaltenden Schnittebene betrachtet eine zumindest abschnittsweise einem Kegelschnitt entsprechende Form; der "Gesamtschwerpunktstrahl" ist als Mittelwert der gesamten von der Sensoreinheit emittierten, nach der Leistung gewichteten Strahlen gebildet und entspricht etwa im Falle einer Abstrahlcharakteristik mit Rotationssymmetrie der Rotationsachse.

Die Oberfläche hat also (in besagter Schnittebene betrachtet) abschnittsweise eine "einem Kegelschnitt entsprechende Form", kann also einen Teil einer Ellipse bzw. eines Kreises oder auch einer Hyperbel bzw. Parabel beschreiben; "abschnittsweise" kann insoweit von einem Brennpunkt der Kegelschnittform aus betrachtet eine sich über einen Winkelbereich von mindestens 45°, 90° bzw. 135° erstreckende Form meinen.

Bei einer bevorzugten Ausführungsform (die besonders bevorzugt mit einer Kegelschnittform kombiniert sein kann) ist die Oberfläche in einer den Gesamtschwerpunktstrahl beinhaltenden Schnittebene betrachtet topfförmig ausgebildet, beispielsweise U- oder V-förmig, und springt ein vorzugsweise umlaufender Rand dieser Topfform gegenüber einem Bereich der Oberfläche, auf welchem die Lichtquellen angeordnet sind, nach innen zurück. In anderen Worten begrenzt ein Oberflächenbereich des Substratkörpers eine Kavität (die Topfform) und verdeckt diese durch einen Kragen (den nach innen zurückspringenden Rand) teilweise.

Der "Oberflächenbereich" kann beispielsweise durch eine die äußeren Lichtquellen der Anordnung tangierende Einhüllende festgelegt sein oder sich etwa auch bis zu einem Bereich erstrecken, in dem sich, etwa in einer den Gesamtschwerpunktstrahl beinhaltenden Schnittebene betrachtet, die Krümmungsrichtung der Substratkörperoberfläche ändert, diese also konvex wird.

Diese Ausführungsform mit "Kragen" ist insbesondere bei Lichtquellen von Interesse, die Licht unterschiedlicher Farbe emittieren, weil in dem Hohlraum eine Lichtmischung erfolgen kann und der nach innen zurückspringende Randbereich zugleich den direkten Blick auf zumindest einige der Bauelemente verdeckt. Der zurückspringende Randbereich stellt in gewisser Hinsicht eine "Hinterschneidung" dar, die sich in besonders vorteilhafter Weise mit einem erfindungsgemäß vorgesehenen spritzgegossenen oder extrudierten Schaltungsträger realisieren lässt.

In bevorzugter Ausgestaltung ist der Substratkörper einstückig ausgebildet, also als monolithisches Bauteil ohne Materialgrenze. Dies bezieht sich selbstverständlich nur auf den Substratkörper selbst, etwa eine an dessen Oberfläche vorgesehene Leiterbahnstruktur ist aus einem metallischen Material.

Neben der der elektrischen Kontaktierung der Sensorenelemente und vorzugsweise Lichtquelle(n) dienenden Leiterbahnstruktur können im Allgemeinen auch strukturierte Beschichtungen zur gerichteten und/oder diffusen Reflexion bzw. Absorption aufgebracht sein, um die optischen Eigenschaften des Substrats lokal zu beeinflussen. Vorzugsweise ist auf der Oberfläche jedoch allein die der elektrischen Kontaktierung dienende Leiterbahnstruktur vorgesehen und sind optische und/oder thermische Eigenschaften durch in den Substratkörper eingebettete Partikel eingestellt.

Die "einstückige" Ausgestaltung schließt also in den Substratkörper eingebettete, darin zufallsverteilte Partikel nicht aus. Ein in den Substratkörper eingebettetes Additiv kann sogar (auch unabhängig von der Einstückigkeit) bevorzugt sein, etwa um der Oberfläche diffuse und/oder gerichtet reflektierende oder gezielt absorbierende Eigenschaften zu verleihen; besonders bevorzugt wird dazu ein Farbpigment in den Substratkörper eingebettet, etwa Titandioxid-Partikel.

Generell kann das Vorsehen einer diffus reflektierenden Oberfläche (zumindest eines Oberflächenbereichs) bevorzugt sein, was im Allgemeinen auch eine gerichtete diffuse (spekular diffuse) Reflexion meinen kann und besonders bevorzugt eine gleichmäßig diffuse Reflexion betrifft, etwa durch eine Beschichtung und/oder Anrauung der Oberfläche. Die Reflektivität im sichtbaren Bereich des Spektrums kann insoweit beispielsweise in dieser Reihenfolge zunehmend bevorzugt mindestens 30 %, 40 %, 50 %, 60 %, 70 %, 80 % bzw. 90 % betragen, besonders bevorzugt bezogen auf eine gleichmäßig diffuse Reflexion.

Bevorzugt kann auch ein gerichtet reflektierender Oberflächenbereich sein, wobei beispielsweise eine Reflektivität von mindestens 90 %, 95 % bzw. 98 % bevorzugt sein kann.

Im Übrigen kann ein Additiv zusätzlich oder auch unabhängig davon auch eine andere Funktion erfüllen, kann also beispielsweise (auch) ein Additiv zur Erhöhung der thermischen Leitfähigkeit des Substratkörpers vorgesehen sein, etwa Partikel aus einer elektrisch nicht leitenden Keramik. Es können beispielsweise Partikel, die BN, AlN, Al₂O₃ und/oder SiC aufweisen, bzw. allein daraus bestehende Partikel in den Substratkörper eingebettet sein. Die Wärmeleitfähigkeit des Substratkörpers kann gegenüber jener des Grundmaterials erhöht sein und beispielsweise in dieser Reihenfolge zunehmend bevorzugt mindestens 2 W/(mK), 4 W/(mK), 6 W/(mK), 8 W/(mK) bzw. 10 W/(mK) betragen. Vorteilhafterweise kann dann beispielsweise auf einen gesonderten Kühlkörper verzichtet werden, was Aufbau und Herstellung vereinfachen kann.

Ferner kann auch ein Additiv zur Erhöhung der Festigkeit des Substratkörpers vorgesehen sein (zusätzlich zur Erhöhung der Reflektivität und/oder Leitfähigkeit oder auch unabhängig davon), was die Freiheit bei der Formgebung, insbesondere Mindestdicken betreffend, erhöhen kann. Es können also beispielsweise Fasern in den Substratkörper eingebettet sein, beispielsweise Glasfasern und/oder ein Mineralfüllstoff.

Generell kann ein symmetrisch aufgebauter Substratkörper bevorzugt sein, etwa ein rotationssymmetrischer Substratkörper. Der Substratkörper kann auch translationssymmetrisch sein, also sich durch Verschiebung, vorzugsweise lineare Verschiebung, eines Teilstücks ergeben, insbesondere im Falle eines extrudierten Schaltungsträgers.

Bevorzugt ist eine Sensoreinheit, bei welcher ausschließlich auf der Oberfläche eine Leiterbahnstruktur zur Verdrahtung der Sensorelemente und ggf. der Lichtquelle(n) vorgesehen ist. Es wird in diesem Fall also auf den Substratkörper durchsetzende Durchkontakte oder dergleichen verzichtet, also auf den Substratkörper von einer zur entgegengesetzten Oberfläche durchsetzende Leiterbahnstücke, was wiederum die Herstellung vereinfachen kann. Besonders bevorzugt ist die Leiterbahnstruktur ausschließlich auf dem auch die Bauelemente tragenden, "inneren" Oberflächenbereich vorgesehen und ist der entgegengesetzte, "äußere" Oberflächenbereich des Substratkörpers frei von der Leiterbahnstruktur.

Ein "innerer", Lichtquellen tragender Oberflächenbereich ist vorzugsweise eher flächig und nicht streifenförmig, haben also die kleinste und die größte Erstreckung dieses Oberflächenbereichs beispielsweise ein Verhältnis von mindestens 1/5, weiter bevorzugt mindestens 1/4, 1/3, 1/2 bzw. 3/4; besonders bevorzugt ist der Oberflächenbereich annähernd quadratisch. Es wird auf die vorstehende Definition von "Oberflächenbereich" verwiesen.

In bevorzugter Ausgestaltung ist ein äußerer Oberflächenbereich, der einem inneren einen Lichtquelle, vorzugsweise eine Mehrzahl Lichtquellen, tragenden Oberflächenbereich entgegengesetzt liegt, als Außenoberfläche eines Leuchtenkörpers vorgesehen. Die erfindungsgemäße Sensoreinheit muss dann also in einer Leuchte nicht rückseitig mit einem Gehäuseelement der Leuchte abgedeckt werden, sondern liegt insoweit frei. In diesem Zusammenhang und auch generell kann bevorzugt sein, dass die Sensorelemente auf dem äußeren Oberflächenbereich angeordnet sind, besonders bevorzugt ausschließlich dort.

Im Falle des als Außenoberfläche einer Leuchte vorgesehenen Oberflächenbereichs trägt nicht nur die das von den Lichtquellen emittierte Licht formende Oberfläche des Substratkörpers, sondern auch eine entgegengesetzte Auβenoberfläche zum ästhetischen Eindruck bei, den die Sensoreinheit/Leuchte auf einen Betrachter hat. Die Erfindung betrifft explizit auch eine solche Leuchte und eine entsprechende Verwendung einer Beleuchtungseinheit.

Generell, auch unabhängig von der eben genannten speziellen Ausgestaltung, richtet sich die Erfindung auch auf eine Leuchte mit einer im Rahmen dieser Offenbarung beschriebenen Sensoreinheit. Generell kann "Leuchte" beispielsweise die über etwa eine Steckdose oder einen Klemm-/Schraub-/Lötkontakt mit dem Stromnetz verbundende Vorrichtung meinen, in welcher dann eine bzw. mehrere Beleuchtungseinheit(en) sitzen, also gehalten sein können.

Die Erfindung betrifft auch einen Satz aus mindestens zwei Sensoreinheiten, bei welchen jeweils das erste und das zweite Sensorelement solchermaßen auf dem Substratkörper angeordnet sind, dass der erste und der zweite Erfassungsbereich zumindest teilweise nicht überlappen. Dabei sind die Substratkörper der mindestens zwei Sensoreinheiten des Satzes zueinander baugleich, also etwa durch Spritzen mit dem gleichen Formwerkzeug oder durch Extrusion mit der gleichen Matrize hergestellt, unterscheiden sie sich jedoch in der Anordnung der jeweiligen Mehrzahl Sensorelemente und haben sie infolgedessen einen unterschiedlichen jeweiligen Gesamterfassungsbereich. Mit nur einem Typ Substratkörper lassen sich somit unterschiedliche Sensoreinheiten realisieren, was die Modularität erhöhen und Herstellungskosten reduzieren helfen kann. Die Sensoreinheiten des Satzes können sich etwa insoweit "unterscheiden", als beispielsweise bei unterstellt deckungsgleich angeordneten Substratkörpern nicht mehr als 90 %, 80 %, 70 %, 60 % bzw. 50 % des Gesamterfassungsbereichs der ersten Sensoreinheit mit dem Gesamterfassungsbereich der zweiten Sensoreinheit überlappen sollen.

Die Erfindung betrifft auch ein Verfahren zum Herstellen einer im Rahmen dieser Offenbarung beschriebenen Sensoreinheit, wobei der Substratkörper aus einem Kunststoffmaterial urgeformt wird, etwa extrudiert oder vorzugsweise spritzgegossen.

Der Begriff "spritzgegossener Schaltungsträger" bezieht sich dabei auf einen Körper, der von einer Kavität freigegeben wird, welcher zuvor zumindest innerhalb gewisser Grenzen fließfähiges Material zugeführt wurde, das in der Kavität zumindest teilweise erhärtet ist. Vorzugsweise wird unter erhöhtem Druck zugeführt, beispielsweise bei mindestens 100 bar, 500 bar, bzw. 1000 bar; mögliche Obergrenzen können etwa bei 3000 bar, 2500 bar oder 2250 bar liegen. Das Härten kann beispielsweise bei einer gegenüber der Zuführtemperatur anderen Härtetemperatur erfolgen, im Falle eines thermoplastischen Materials beispielsweise bei geringerer und im Falle eines duroplastischen Materials etwa bei höherer Temperatur.

Auch unabhängig vom Spritzgießen kann als "Kunststoffmaterial" beispielsweise Polypropylen (PP, insbesondere strahlenvernetzt), Polyamid (zum Beispiel PA6, PA66, PA10, PA11, PA12), insbesondere hochtemperaturbeständiges Polyamid wie PPA oder PA46, Polyester (zum Beispiel PBT, PET, PBT/PET, PCT, ABS, ABS/PC), Polyphenylensulfid, LCP und/oder PEEK vorgesehen sein.

Die Leiterbahnstruktur kann prinzipiell beispielsweise im Rahmen eines Mehrkomponentenspritzgusses aufgebracht werden, wobei als eine Komponente der Substratkörper spritzgegossen wird und als andere Komponente etwa ein metallisierbarer Kunststoff, der anschließend elektronisch und/oder stromlos in einem Bad beschichtet wird. In ein Spritzgusswerkzeug kann auch ein Träger mit der Leiterbahnstruktur eingelegt und hinterspritzt werden. Die Leiterbahnstruktur kann bei einer solchen *In-mold* Technik beispielsweise auch durch Stempeln oder Sprühen in das Spritzgusswerkzeug eingebracht werden. Ferner kann die Leiterbahnstruktur beispielsweise auch in einem Heißprägeverfahren auf den zuvor spritzgegossenen Substratkörper aufgeprägt werden, etwa von einer in der Prägepresse zugleich gestanzten Metallfolie ausgehend.

Es ist auch möglich, die Leiterbahnstruktur durch Laser-Direkt-Strukturierung aufzubringen, wobei ein Laserstrahl auf der Oberfläche des (z. B. spritzgegossenen oder extrudierten) Substratkörpers die Leiterbahnstruktur "schreibt" und dabei in den Substratkörper eingebettete Keime für die nachfolgende Metallisierung freilegt. Andererseits kann die Leiterbahnstruktur auch mit aus der Halbleiterherstellung bekannten Verfahren aufgebracht werden, also durch entsprechende Maskierung, wobei in freigelegten Bereichen einer großflächig aufgebrachten (Lack)maske beispielsweise die Leiterbahnstruktur aufwachsen kann oder eine zuvor abgeschiedene Metallschicht (unter der (Lack)maske) entfernt werden kann, beispielsweise durch Ätzen. Ebenfalls möglich ist eine Plasmaabscheidung, wiederum in Verbindung mit einer Maskierung.

Die Erfindung betrifft auch die Verwendung einer Sensoreinheit für eine Leuchte, insbesondere eine Leuchte zur Allgemeinbeleuchtung, insbesondere zur Beleuchtung mit einer ortsfesten Leuchte, vorzugsweise zur Beleuchtung eines Gebäudes, etwa dessen unmittelbaren Umfelds bzw. vorzugsweise dessen Inneren, insbesondere zur Ausleuchtung einer Arbeitsfläche, etwa eines Schreibtischs.

### Kurze Beschreibung der Zeichnungen

Im Folgenden wird die Erfindung anhand eines Ausführungsbeispiels näher erläutert, wobei auch weiterhin nicht im Einzelnen zwischen den Anspruchskategorien unterschieden wird und die Merkmale im Rahmen der unabhängigen Ansprüche auch in anderer Kombination offenbart sein sollen.
Fig. 1 zeigt eine erfindungsgemäße Sensoreinheit mit Sensorelementen und LEDs.
Fig. 2 zeigt eine weitere erfindungsgemäße Sensoreinheit.

### Bevorzugte Ausführung der Erfindung

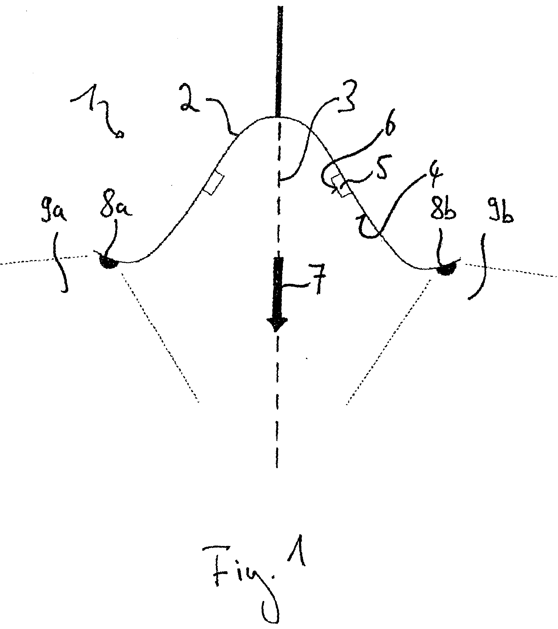

Fig. 1 zeigt eine erfindungsgemäße Sensoreinheit 1 mit einem spritzgegossenen Substratkörper 2 in einer Schnittdarstellung; der Substratkörper 2 ist zu einer in der Zeichenebene liegenden Achse 3 rotationssymmetrisch aufgebaut.

Auf einer Innenfläche 4 des Substratkörpers 2 sind über den Umlauf um die Rotationsachse 3 verteilt eine Mehrzahl LEDs 5 vorgesehen, und zwar vorliegend insgesamt zehn LEDs 5. Die LEDs 5 sind jeweils für sich gehäust, werden also bei der Herstellung der Sensoreinheit 1 als bereits gehäuste Bauelemente auf die Innenfläche 4 gesetzt. Das von den LEDs 5 an einer jeweiligen Abstrahlfläche 6 jeweils lambertsch emittierte Licht fällt zum Teil auf die Innenfläche 4, die aufgrund von in den Substratkörper 2 eingebetteten Titandioxid-Partikeln diffus reflektierend ist; der Substratkörper 2, also der Verlauf dessen Innenfläche 4, bestimmt die Abstrahlcharakteristik mit.

Aufgrund des rotationssymmetrischen Substratkörpers 2 und der hinsichtlich der Umlaufrichtung äquidistanten Anordnung der LEDs 5 ist der Gesamtschwerpunktstrahl 7 entlang der Rotationsachse 3 orientiert.

Erfindungsgemäß sind auf dem Substratkörper 2 eine Mehrzahl Sensorelemente 8 vorgesehen, die einen jeweiligen Erfassungsbereich 9 haben. Vorliegend sind vier Sensorelemente 8 auf dem Substratkörper 2 angeordnet, und zwar hinsichtlich der Umlaufrichtung mit einem Abstand von 90° zwischen jeweils nächst benachbarten Sensorelementen 8.

Der erste Erfassungsbereich 9a des ersten Sensorelements 8a überlappt nur zum Teil mit dem zweiten Erfassungsbereich 9b des zweiten Sensorelements 8b, die Sensorelemente 8a,b ergänzen sich also aufgrund ihrer räumlichen Anordnung. Der sich insgesamt ergebende Gesamterfassungsbereich ist größer als jeder der einzelnen Erfassungsbereiche 9a,b. Dies ist insofern vorteilhaft, als die vorliegend zur Bewegungsdetektion eingesetzten passiven Infrarotsensorelemente 8a,b jeweils für sich allein keine beliebig großen Winkelbereiche abdecken können.

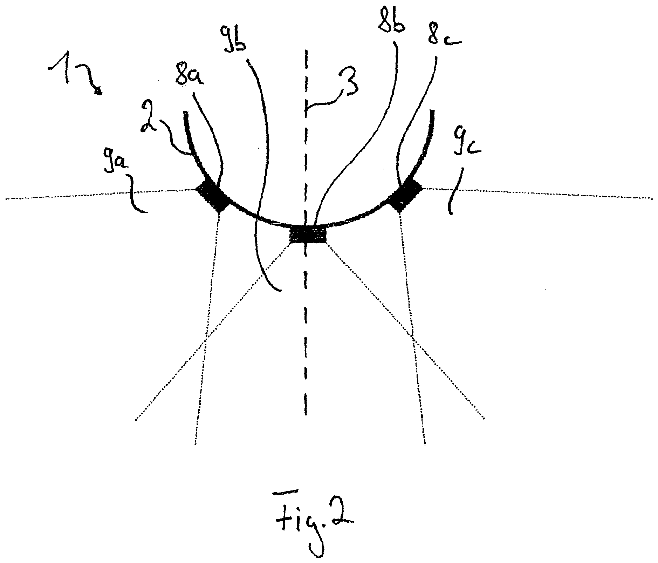

Fig. 2 zeigt eine weitere Sensoreinheit 1, deren spritzgegossener Substratkörper 2 ebenfalls zu einer Achse 3 rotationssymmetrisch aufgebaut ist. Der Substratkörper 2 hat die Form einer Halbkugel und ist in Figur 2 in einer die Achse 3 beinhaltenden Schnittebene dargestellt.

In dieser Schnittdarstellung sind ein erstes 8a, ein zweites 8b und ein drittes Sensorelement 8c zu erkennen, wobei es sich um zur Bewegungsdetektion vorgesehene Pyrosensoren handelt, die aufgrund einer jeweiligen Facettierung (nicht dargestellt) die Detektion einer Bewegung ermöglichen. Durch die Anordnung der Sensorelemente 8a, b, c wird einerseits der Gesamterfassungsbereich vergrößert; andererseits kann aufgrund der Überlappung auch die Auflösung erhöht werden, insbesondere in größerer Entfernung.

## Patentansprüche

1. Sensoreinheit (1) zur Lichtsteuerung mit einer optoelektronischen Lichtquelle und mit einem Substratkörper (2), auf dem eine Mehrzahl Sensorelemente (8a, b) angeordnet sind, welche zur Erfassung von Daten ausgebildet sind, wobei die Daten dazu geeignet sind, einer Steuereinheit zur Steuerung der optoelektronischen Lichtquelle (5) zugeführt zu werden, wobei ein erstes Sensorelement (8a) der Mehrzahl Sensorelemente (8a, b) einen ersten Erfassungsbereich (9a) zur Erfassung einer ersten Erfassungsgröße hat und ein zweites Sensorelement (8b) der Mehrzahl Sensorelemente (8a, b) einen zweiten Erfassungsbereich (9b) zur Erfassung einer zweiten Erfassungsgröße hat,
und wobei
das erste (8a) und das zweite Sensorelement (8b) solchermaßen auf dem Substratkörper (2) angeordnet sind, dass der erste (9a) und der zweite Erfassungsbereich (9b) zumindest teilweise nicht überlappen und/oder
die erste und die zweite Erfassungsgröße hinsichtlich ihrer Art verschieden sind,
**dadurch gekennzeichnet, dass** der Substratkörper (2) als urgeformter Schaltungsträger aus einem Kunststoffmaterial vorgesehen ist,
wobei der Substratkörper (2) einen Oberflächenbereich hat, der zumindest teilweise konvex ist, wobei von dem erstem Sensorelement (8a) und dem zweiten Sensorelement (8b) zumindest eines in dem zumindest teilweise konvexen Oberflächenbereich angeordnet ist,
und wobei die optoelektronische Lichtquelle (5) derart auf der Oberfläche des Substratkörpers (2) angeordnet ist, dass ein Teil des von der optoelektronischen Lichtquelle (5) emittierten Lichts auf die Oberfläche des Substratkörpers (2) fällt.

2. Sensoreinheit (1) nach Anspruch 1, bei welcher das erste (8a) und das zweite Sensorelement (8b) solchermaßen auf dem Substratkörper (2) angeordnet sind, dass nicht mehr als 50 % des ersten Erfassungsbereichs (9a) mit dem zweiten Erfassungsbereich (9b) überlappen.

3. Sensoreinheit (1) nach einem der vorstehenden Ansprüche, bei welcher zumindest eines von dem erstem Sensorelement (8a) und zweitem Sensorelement (8b) dazu ausgelegt ist, eine Bewegung eines sich gegenüber dem jeweiligen Sensorelement (8a, b) bewegenden Objekts zu erfassen.

4. Sensoreinheit (1) nach einem der vorstehenden Ansprüche, bei welcher das erste Sensorelement (8a) dazu ausgelegt ist, zumindest eines von einer absoluten Helligkeit und eine Helligkeitsänderung zu messen.

5. Sensoreinheit (1) nach einem der vorstehenden Ansprüche, bei welcher die optoelektronische Lichtquelle (5) auf dem Substratkörper (2) angeordnet und dazu ausgelegt ist, in Abhängigkeit von einem von den Sensorelementen (8a, b) erfassten Wert Licht zu emittieren.

6. Sensoreinheit (1) nach einem der Ansprüche 1 bis 5, bei welcher eine zweite optoelektronische Lichtquelle (5) auf dem Substratkörper (2) angeordnet ist, und zwar in dem Bereich der Oberfläche, auf welchen ein Teil des von der ersten Lichtquelle (5) emittierten Lichts direkt fällt.

7. Sensoreinheit (1) nach einem der vorstehenden Ansprüche, bei welcher der Substratkörper (2) einstückig ausgebildet ist.

8. Sensoreinheit (1) nach einem der vorstehenden Ansprüche, bei welcher der Substratkörper (2) ein spritzgegossener Schaltungsträger ist.

9. Sensoreinheit (1) nach einem der Ansprüche 1 bis 8, bei welcher zumindest ein Oberflächenbereich des Substratkörpers (2), der einem die optoelektronische Lichtquelle (5) tragenden Oberflächenbereich entgegengesetzt angeordnet ist, als Außenoberfläche einer Leuchte vorgesehen ist.

10. Leuchte mit einer Sensoreinheit (1) nach einem der vorstehenden Ansprüche.

11. Satz aus mindestens zwei Sensoreinheiten (1) nach einem der vorstehenden Ansprüche, bei welchen jeweils das erste (8a) und das zweite Sensorelement (8b) solchermaßen auf dem Substratkörper (2) angeordnet sind, dass der erste (9a) und der zweite Erfassungsbereich (9b) zumindest teilweise nicht überlappen, und die jeweils einen entsprechenden Gesamterfassungsbereich haben, der sich je Sensoreinheit (8a, b) aus der Gesamtheit der jeweiligen Erfassungsbereiche ergibt, wobei die Substratkörper (2) der mindestens zwei Sensoreinheiten (1) des Satzes zueinander baugleich sind, sich die mindestens zwei Sensoreinheiten (1) jedoch in der Anordnung der jeweiligen Mehrzahl Sensorelemente (8a, b) solchermaßen unterscheiden, dass sich die mindestens zwei Sensoreinheiten (1) hinsichtlich ihres jeweiligen Gesamterfassungsbereichs unterscheiden.

12. Verfahren zum Herstellen einer Sensoreinheit (1) nach einem der Ansprüche 1 bis 9, bei welchem der Substratkörper (2) aus einem Kunststoffmaterial urgeformt wird.

13. Verwendung einer Sensoreinheit (1) nach einem der Ansprüche 1 bis 9 für eine Leuchte, insbesondere zur Allgemeinbeleuchtung, insbesondere zur Beleuchtung mit einer ortsfesten Leuchte, insbesondere zur Beleuchtung eines Gebäudes, insbesondere zur Innenbeleuchtung eines Gebäudes.

## Claims

1. Sensor unit (1) for light control comprising an optoelectronic light source and comprising a substrate body (2), arranged on which there are a plurality of sensor elements (8a, b) which are equipped to capture data, wherein the data are suitable to be fed to a control unit for controlling the optoelectronic light source (5),
wherein a first sensor element (8a) of the plurality of sensor elements has a first detection region (9a) for detecting a first detection variable and a second sensor element (8b) of the plurality of sensor elements (8a, b) has a second detection region (9b) for detecting a second detection variable,
and wherein
the first sensor element (8a) and the second sensor element (8b) are arranged on the substrate body (2) in such a way that the first detection region (9a) and the second detection region (9b) at least partly do not overlap and/or
the first detection variable and the second detection variable are different with regard to their type,
**characterized in that** the substrate body (2) is provided as a primary-formed circuit carrier composed of a plastics material,
wherein the substrate body (2) has a surface region that is at least partly convex, wherein at least one of the first sensor element (8a) and the second sensor element (8b) is arranged in the at least partly convex surface region,
and wherein the optoelectronic light source (5) is arranged on the surface of the substrate body (2) in such a way that part of the light emitted by the optoelectronic light source (5) is incident on the surface of the substrate body (2).

2. Sensor unit (1) according to Claim 1, wherein the first sensor element (8a) and the second sensor element (8b) are arranged on the substrate body (2) in such a way that no more than 50% of the first detection region (9a) overlaps the second detection region (9b).

3. Sensor unit (1) according to either of the preceding claims, wherein at least one of the first sensor element (8a) and the second sensor element (8b) is designed to detect a movement of an object moving relative to the respective sensor element (8a, b).

4. Sensor unit (1) according to any one of the preceding claims, wherein the first sensor element (8a) is designed to measure at least one of an absolute brightness and a change in brightness.

5. Sensor unit (1) according to any one of the preceding claims, wherein the optoelectronic light source (5) is arranged on the substrate body (2) and designed to emit light depending on a value detected by the sensor elements (8a, b).

6. Sensor unit (1) according to any one of Claims 1 to 5, wherein a second optoelectronic light source (5) is arranged on the substrate body (2), specifically in that region of the surface on which part of the light emitted by the first light source (5) is incident directly.

7. Sensor unit (1) according to any one of the preceding claims, wherein the substrate body (2) is embodied in an integral fashion.

8. Sensor unit (1) according to any one of the preceding claims, wherein the substrate body (2) is an injection-moulded circuit carrier.

9. Sensor unit (1) according to any one of Claims 1 to 8, wherein at least one surface region of the substrate body (2) that is arranged oppositely to a surface region carrying the optoelectronic light source (5) is provided as an exterior surface of a luminaire.

10. Luminaire comprising a sensor unit (1) according to any one of the preceding claims.

11. Set of at least two sensor units (1) according to any one of the preceding claims, wherein in each case the first sensor element (8a) and the second sensor element (8b) are arranged on the substrate body (2) in such a way that the first detection region (9a) and the second detection region (9b) at least partly do not overlap, and which in each case have a corresponding total detection region resulting, per sensor unit (8a, b), from the totality of the respective detection regions, wherein the substrate bodies (2) of the at least two sensor units (1) of the set are structurally identical to one another, but the at least two sensor units (1) differ in the arrangement of the respective plurality of sensor elements (8a, b) in such a way that the at least two sensor units (1) differ with regard to their respective total detection region.

12. Method for producing a sensor unit (1) according to any one of Claims 1 to 9, wherein the substrate body (2) is primary formed from a plastics material.

13. Use of a sensor unit (1) according to any one of Claims 1 to 9 for a luminaire, in particular for general lighting, in particular for lighting with a stationary luminaire, in particular for the lighting of a building, in particular for the interior lighting of a building.

## Revendications

1. Unité de capteur (1) pour la commande de lumière avec une source de lumière optoélectronique et avec un corps de substrat (2) sur lequel sont disposés une pluralité d'éléments de capteur (8a, b) qui sont constitués pour la captation de données,
les données étant appropriées pour être acheminées à une unité de commande pour la commande de la source de lumière optoélectronique (5), un premier élément de capteur (8a) de la pluralité d'éléments de capteur (8a, b) ayant une première zone de captation (9a) pour la captation d'une première grandeur de captation, et un deuxième élément de capteur (8b) de la pluralité d'éléments de capteur (8a, b) ayant une deuxième zone de captation (9b) pour la captation d'une deuxième grandeur de captation,
et
le premier (8a) et le deuxième élément de capteur (8b) étant disposés sur le corps de substrat (2) de telle manière que la première (9a) et la deuxième zone de captation (9b) ne se chevauchent pas, au moins partiellement, et/ou
la première et la deuxième grandeur de captation étant d'un type différent, **caractérisée en ce que** le corps de substrat (2) est prévu en tant que support de circuit formé initialement en matières plastique,
le corps de substrat (2) ayant une zone superficielle qui est au moins partiellement convexe, au moins un élément parmi le premier élément de capteur (8a) et le deuxième élément de capteur (8b) étant disposé dans la zone superficielle au moins partiellement convexe,
et la source de lumière optoélectronique (5) étant disposée sur la surface du corps de substrat (2) de telle sorte qu'une partie de la lumière émise par la source de lumière optoélectronique (5) tombe sur la surface du corps de substrat (2).

2. Unité de capteur (1) selon la revendication 1, dans laquelle le premier (8a) et le deuxième élément de capteur (8b) sont disposés sur le corps de substrat (2) de telle manière que pas plus de 50 % de la première zone de captation (9a) se chevauchent avec la deuxième zone de captation (9b).

3. Unité de capteur (1) selon l'une des revendications précédentes, dans laquelle au moins un élément parmi le premier élément de capteur (8a) et le deuxième élément de capteur (8b) est conçu pour capter un mouvement d'un objet se déplaçant par rapport à l'élément de capteur (8a, b) respectif.

4. Unité de capteur (1) selon l'une des revendications précédentes, dans lequel le premier élément de capteur (8a) est conçu pour mesurer au moins une valeur parmi une luminosité absolue et une variation de luminosité.

5. Unité de capteur (1) selon l'une des revendications précédentes, dans laquelle la source de lumière optoélectronique (5) est disposée sur le corps de substrat (2) et est conçue pour émettre de la lumière en fonction d'une valeur captée par les éléments de capteur (8a, b).

6. Unité de capteur (1) selon l'une des revendications 1 à 5, dans laquelle une deuxième source de lumière optoélectronique (5) est disposée sur le corps de substrat (2), et cela dans la zone de la surface sur laquelle tombe une partie de la lumière émise par la première source de lumière (5).

7. Unité de capteur (1) selon l'une des revendications précédentes, dans laquelle le corps de substrat (2) est constitué d'une seule pièce.

8. Unité de capteur (1) selon l'une des revendications précédentes, dans laquelle le corps de substrat (2) est un support de circuit moulé par injection.

9. Unité de capteur (1) selon l'une des revendications 1 à 8, dans laquelle au moins une zone superficielle du corps de substrat (2), qui est disposée de manière opposée à la zone superficielle portant la source de lumière optoélectronique (5), est prévue en tant que surface extérieure d'un luminaire.

10. Luminaire avec une unité de capteur (1) selon l'une des revendications précédentes.

11. Jeu d'au moins deux unités de capteur (1) selon l'une des revendications précédentes, dans lesquelles respectivement le premier (8a) et le deuxième élément de capteur (8b) sont disposés sur le corps de substrat (2) de telle manière que la première (9a) et la deuxième zone de captation (9b) ne se chevauchent pas, au moins partiellement, et qui ont respectivement une zone de captation totale correspondante qui, par pour chaque unité de capteur (8a, b), résulte de la totalité des zones de captation respectives, les corps de substrat (2) des au moins deux unités de capteur (1) du jeu étant de construction identique entre eux, les au moins deux unités de capteur (1) se distinguant cependant par la disposition de la pluralité respective d'éléments de capteur (8a, b) de telle manière que les au moins deux unités de capteur (1) se distinguent en ce qui concerne leur zone de captation totale respective.

12. Procédé de fabrication d'une unité de capteur (1) selon l'une des revendications 1 à 9, dans lequel le corps de substrat (2) est formé initialement en matière plastique.

13. Utilisation d'une unité de capteur (1) selon l'une des revendications 1 à 9 pour un luminaire, en particulier pour l'éclairage général, en particulier pour l'éclairage avec un luminaire stationnaire, en particulier pour l'éclairage d'un bâtiment, en particulier pour l'éclairage intérieur d'un bâtiment.
